# FASCICULE DE BREVET EUROPEEN

(11) **EP 0 638 904 B1**
(45) Date de publication et mention de la délivrance du brevet: **05.01.2000**
(21) Numéro de dépôt: 94410047.8
(22) Date de dépôt: 08.07.1994
(51) Int. Cl.: G11C 8/00, H03K 23/54, H03K 19/003, G11C 19/00

(54) **Mémoire à double accès**
Doppelzugriffspeicher
Dual-port memory

(30) Priorité: 12.07.1993 FR 9308837
(43) Date de publication de la demande: 15.02.1995
(60) Demande divisionnaire: 98201225.4
(73) Titulaire: STMicroelectronics S.A., 94250 Gentilly (FR)
(72) Inventeur: Artieri, Alain, F-38240 Meylan (FR)
(74) Mandataire: de Beaumont, Michel

(56) Documents cités:
- EP-A- 0 390 453
- EP-A- 0 422 939
- US-A- 4 849 935
- US-A- 4 864 543
- 1990 SYMPOSIUM ON VLSI CIRCUITS DIGEST OF TECHNICAL PAPERS, 7 Juin 1990, HONOLULU, US pages 65 - 66 SAKAUE ETA L 'A 0.8um BiCMOS ATM switch on the 800Mbps asynchronous buffered banyan network'
- PROCEEDINGS OF THE IEEE 1989 CUSTOM INTEGRATED CIRCUITS CONFERENCE, 15 Mai 1989, SAN DIEGO, US pages 23.4.1 - 23.4.4 KAWAUCHI ET AL 'A 1.0um compilable FIFO buffer for standard cell'

## Description

La présente invention concerne les mémoires à double accès, c'est-à-dire qui comprennent une entrée et une sortie distinctes, et plus particulièrement les mémoires de type premier-entré/premier-sorti (FIFO).

Le document "1990 SYMPOSIUM ON VLSI CIRCUITS DIGEST OF TECHNICAL PAPERS, 7 Juin 1990, HONOLULU, US pages 65 - 66 SAKAUE ETA L 'A 0.8um BiCMOS ATM switch on the 800Mbps asynchronous buffered banyan network' " présente une mémoire à double access dont les cellules sont reliées à des lignes de bit différentielles.

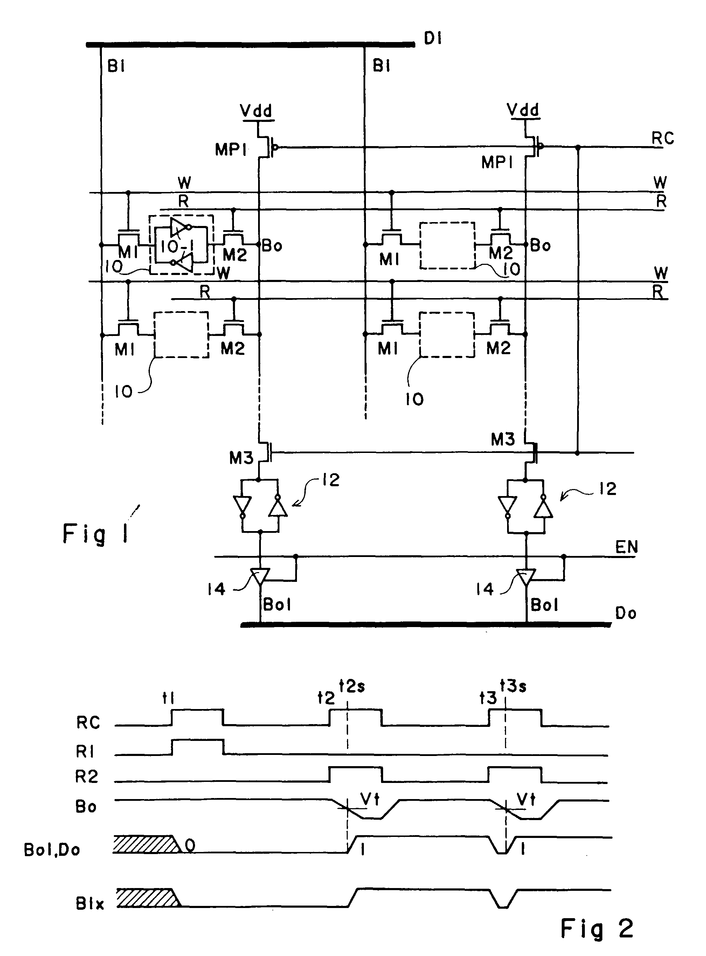

La figure 1 représente partiellement une structure de mémoire double accès classique. Cette mémoire comprend des cellules mémoire à double accès 10 disposées par colonnes. Comme cela est représenté, chaque oellule 10 comprend, par exemple, deux inverseurs 10-1 disposés tête-bêche. Chaque inverseur comprend une paire de transistors de sortie complémentaires (MOS à canaux N et P). L'entrée et la sortie de la cellule correspondent respectivement à l'entrée et à la sortie d'un premier des inverseurs. Le deuxième inverseur, dont la sortie est reliée à l'entrée de la cellule mémoire, comprend des transistors de sortie plus résistifs que ceux du premier inverseur, ce qui limite la consommation de courant lors d'une écriture dans la cellule.

A chaque colonne de cellules est associée une ligne d'entrée Bi et une ligne de sortie Bo. L'entrée de chaque cellule 10 d'une colonne est reliée à la ligne d'entrée correspondante Bi par un transistor MOS à canal N M1. La sortie de chaque cellule 10 d'une colonne est reliée à la ligne de sortie Bo correspondante par un transistor MOS à canal N M2. Les grilles des transistors M1 d'une même rangée de cellules sont reliées à une ligne d'écriture W et les grilles des transistors M2 d'une même rangée de cellules sont reliées à une ligne de lecture R.

Chaque ligne de sortie Bo est reliée à un potentiel d'alimentation haut Vdd par un transistor MOS à canal P MP1, dit transistor de précharge. Chaque ligne de sortie Bo est reliée à une sortie Bo1 de la mémoire par successivement un transistor MOS à canal N M3, un verrou 12 constitué d'inverseurs disposés tête-bêche, et une porte trois états 14.

Les transistors MP1 et M3 sont commandés par un signal RC de lecture de colonne. Les portes trois états 14 sont commandées par un signal de validation EN qui, selon le cas, est égal au signal RC ou fixé par un dispositif externe, tel qu'un microprocesseur, qui lit la mémoire. Les transistors de précharge MP1 peuvent aussi être à canal N ; dans ce cas ils sont commandés par l'inverse logique du signal RC.

Dans une configuration classique courante, les lignes d'entrée Bi sont reliées directement, ou par l'intermédiaire d'amplificateurs suiveurs non représentés, à des lignes respectives d'un bus de données d'entrée Di. Les sorties Bo1 de la mémoire sont reliées aux lignes respectives d'un bus de sortie Do. Ainsi, à des bus de données Di et Do de n lignes, on associe des mémoires à double accès de n colonnes.

Les lignes d'écriture W et de lecture R sont commandées par un décodeur d'adresses non représenté. Pour écrire dans la mémoire, un dispositif gérant le bus d'entrée Di présente une donnée sur le bus Di, émet une adresse (sur un bus d'adresses non représenté) qui sélectionne l'une des rangées de cellules, et active une ligne d'écriture de colonne WC (non représentée à la figure 1).

Pour lire dans la mémoire, un dispositif qui gère le bus Do émet une adresse qui sélectionne l'une des rangées de cellules, active la ligne RC de lecture de colonne, et valide la ligne EN.

Les mémoires à double accès du type de la figure 1 sont souvent utilisées dans des mémoires de type premier-entré/premier-sorti (FIFO). Une mémoire FIFO ne comprend pas de bus d'adresses. Pour lire dans une mémoire FIFO, on active la ligne RC de lecture de colonne et on récupère la donnée que la mémoire présente alors sur sa sortie (Bo1). Pour écrire dans la mémoire FIFO, on active la ligne WC d'écriture de colonne en présentant une donnée à son entrée (Bi).

Une mémoire FIFO comprend généralement une mémoire à double accès du type de la figure 1 avec son décodeur d'adresses, les adresses étant fournies par un circuit de commande, relativement complexe, qui gère le mécanisme du "premier-entré/premier-sorti" en fonction des signaux de lecture WC et d'écriture RC de colonne, fournis de l'extérieur.

La figure 2 représente l'allure de divers signaux de la structure de la figure 1 lors de la lecture successive d'un "0" dans une première cellule et de deux fois un "1" dans une deuxième cellule. A des instants t1, t2 et t3 successifs, on décide d'effectuer les lectures susmentionnées.

A l'instant t1, on active la ligne de lecture de colonne RC et une ligne R1 qui correspond à l'une des lignes de lecture R. Le transistor M2 est rendu passant et transmet la sortie de la cellule 10 sur la ligne de sortie Bo. Le transistor MP1 est bloqué et la ligne Bo n'est pas forcée au potentiel Vdd. La cellule 10 lue stocke un "0", ce qui veut dire que l'entrée de la cellule est à "0" alors que sa sortie est à "1". Ainsi, la ligne Bo reste à "1". Le transistor M3 est rendu passant et transmet l'état "1" de la ligne Bo sur l'entrée du verrou 12 qui inverse cet état. Ainsi, la sortie Bo1, et la ligne correspondante du bus Do, passent ou restent à "0". Les lignes RC et R1 sont désactivées avant l'instant t2, ce qui rend conducteurs les transistors de précharge MP1 et bloque les transistors de sortie M3.

A l'instant t2, on décide de lire un "1" dans une deuxième cellule mémoire. La ligne RC est de nouveau activée et l'on active une ligne R2 correspondant à une autre ligne de lecture R. Cette fois-ci, la sortie de la cellule 10 lue est à "0". La ligne Bo passe lentement de Vdd à 0 en se déchargeant vers la sortie de la cellule 10 par le transistor M2, la sortie de la cellule 10 étant forcée à la masse par un transistor de la cellule. Le verrou 12 ne bascule que quand l'état de la ligne Bo atteint un seuil de basculement Vt à un instant t2s. Ainsi, la sortie Bo1 passe à "1" avec un certain retard par rapport à l'instant t2. Avant l'instant t3, les lignes RC et R2 sont désactivées, ce qui entraîne la remise à "1" des lignes de sortie Bo.

A l'instant t3, on lit la même cellule qu'à l'instant t2. Les lignes RC et R2 sont de nouveau activées. Comme à l'instant t2, la ligne Bo passe progressivement de Vdd à 0 en se déchargeant par le transistor M2 vers la sortie de la cellule lue. Toutefois, entre l'instant t3 et l'instant t3s où l'état de la ligne Bo atteint la tension seuil Vt, le verrou 12, dont l'entrée était à 0, bascule à l'instant t3, et bascule de nouveau à l'instant t3s. Ceci entraîne, comme cela est représenté, un passage intempestif à "0" de la sortie Bo1 entre les instants t3 et t3s.

On a également représenté, sous la référence Biₓ, l'allure d'une ligne d'entrée d'une deuxième mémoire à double accès dont l'entrée serait reliée au bus Do. L'état de cette ligne Biₓ varie de la même manière que la sortie correspondante Bo1.

Une mémoire du type de la figure 1, comme tout circuit CMOS, ne consomme du courant que lors des transitions des signaux qui y transitent. Ainsi, la consommation d'une telle mémoire est indûment augmentée du fait des passages à "0" intempestifs de la sortie Do1 entre deux lectures d'un "1". La consommation est en outre d'autant plus grande que les lignes sur lesquelles transitent ces signaux sont longues. Ainsi, la consommation devient particulièrement importante si la sortie d'une première mémoire à double accès est reliée aux entrées de plusieurs autres mémoires à double accès.

Un objet de la présente invention est de prévoir une structure de mémoire à double accès présentant une consommation particulièrement faible.

Un autre objet de la présente invention est de prévoir une mémoire FIFO à consommation particulièrement faible et de structure particulièrement simple.

Ces objets sont atteints grâce à une mémoire à double accès comprenant des cellules mémoire à double accès disposées en colonnes. Une ligne de sortie par colonne est reliée à chaque cellule de la colonne par un transistor de lecture commandé par une ligne de lecture respective. Des transistors de précharge relient les lignes de sortie à un potentiel de précharge correspondant à un premier état logique, ces transistors étant commandés par un état inactif d'un signal de sélection en lecture. Des transistors de sortie relient les lignes de sortie à une sortie de la mémoire. Une fausse cellule mémoire est associée à une fausse ligne de sortie et à un transistor de précharge, la sortie de cette fausse cellule étant à un deuxième état logique opposé audit premier état logique. Un faux transistor de lecture est commandé par l'état actif du signal de sélection en lecture et relie la sortie de la fausse cellule à la fausse ligne de sortie. Des moyens sont prévus pour commander lesdits transistors de sortie lorsque l'état de la fausse ligne de sortie atteint un seuil prédéterminé entre lesdits premier et deuxième états logiques.

Selon un mode de réalisation de la présente invention, une ligne d'entrée par colonne est reliée à chaque cellule de la colonne par un transistor d'écriture commandé par une ligne d'écriture respective. La mémoire comprend, pour chaque ligne d'écriture, un transistor reliant cette ligne d'écriture à une entrée de la mémoire et commandé par l'état actif d'un signal de sélection en écriture.

Selon un mode de réalisation de la présente invention, les moyens pour commander les transistors de sortie comprennent une porte logique dont une première entrée est reliée à la fausse ligne de sortie par l'intermédiaire d'un inverseur et dont une deuxième entrée reçoit le signal de sélection en lecture.

Selon un mode de réalisation de la présente invention, la fausse cellule comprend un transistor conducteur relié à un potentiel fixe correspondant audit deuxième état logique.

Selon un mode de réalisation de la présente invention, la mémoire est une mémoire de type premier-entrée/premier-sorti comprenant : un premier registre à décalage rebouclé dont les sorties commandent respectivement les lignes de lecture, le décalage de ce registre étant commandé par l'inverse du signal de sélection en lecture ; et un deuxième registre à décalage rebouclé dont les sorties commandent respectivement lesdites lignes d'écriture, le décalage de ce registre étant commandé par l'inverse du signal de sélection en écriture.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, représente partiellement une structure de mémoire à double accès classique ;
la figure 2 représente l'allure de divers signaux de la mémoire de la figure 1 lors de cycles de lecture ;
la figure 3 représente partiellement un mode de réalisation de structure de mémoire à double accès selon la présente invention ;
la figure 4 représente les allures de divers signaux de la mémoire de la figure 3 lors d'un cycle de lecture ;
la figure 5 représente un mode de réalisation selon la présente invention d'un circuit de commande des lignes de lecture et d'écriture d'une mémoire FIFO ; et
la figure 6 représente un exemple de circuit permettant de générer des signaux d'état d'une mémoire FIFO munie du circuit de commande de la figure 5.

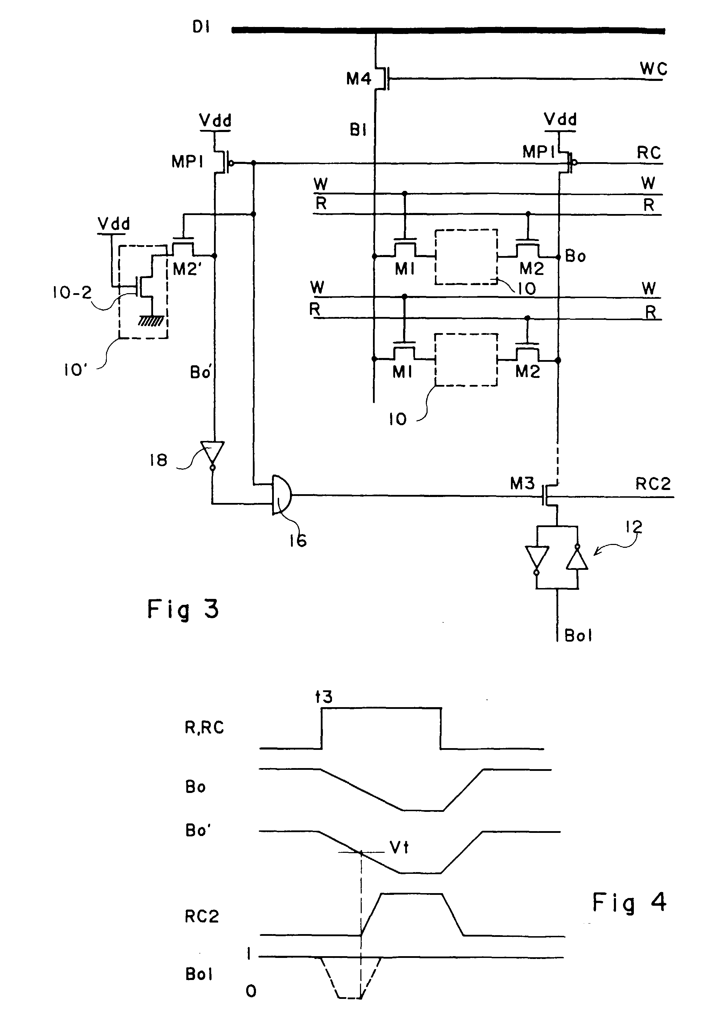

A la figure 3, des mêmes éléments qu'à la figure 1 sont désignés par des mêmes références.

Selon l'invention, il est prévu une fausse cellule mémoire 10' pour l'ensemble des colonnes de cellules, la sortie de cette fausse cellule étant reliée à une fausse ligne de sortie Bo' par un transistor MOS à canal N M2'. La sortie de cette fausse cellule 10' est fixée en permanence à "0" par un transistor MOS à canal N 10-2, relié entre le transistor M2' et la masse, et dont la grille est reliée au potentiel Vdd. Les transistors M2' et 10-2 sont choisis avec les mêmes caractéristiques, respectivement, que les transistors M2 et le transistor de sortie à canal N d'une cellule mémoire.

La fausse ligne de sortie Bo' est reliée au potentiel Vdd, comme les autres lignes de sortie Bo, par un transistor de précharge MP1 dont la grille est commandée par le signal de lecture de colonne RC. Contrairement aux transistors de lecture M2, la grille du transistor M2' de lecture de la fausse cellule est reliée à la ligne RC. Avec cette configuration, la fausse cellule 10' est "lue" en même temps que l'une quelconque des autres cellules et la fausse ligne de sortie Bo' se comporte exactement de la même manière que la ligne Bo de la vraie cellule lue.

Les grilles des transistors de sortie M3, au lieu d'être reliées à la ligne RC, sont reliées à une ligne RC2 connectée à la sortie d'une porte ET 16. Une première entrée de la porte ET 16 est reliée à la ligne RC et l'autre à la fausse ligne de sortie Bo' par l'intermédiaire d'un inverseur 18.

La figure 4 représente l'allure de divers signaux de la mémoire de la figure 3 lors de la lecture d'un "1" dans une cellule mémoire alors qu'un "1" a précédemment été lu dans une cellule de la même colonne. Ce cas correspond à l'instant t3 de la figure 2 où la sortie d'une mémoire classique présentait un passage à "0" intempestif.

A l'instant t3, les lignes R et RC sont activées. Les transistors de précharge MP1 sont bloqués, le transistor M2' et le transistor M2 de la cellule à lire deviennent passants. La sortie de la fausse cellule 10' et la sortie de la cellule 10 à lire sont à "0", ce qui provoque, comme cela est représenté, une décharge progressive et synchrone des lignes de sortie Bo et Bo'. Lors d'une première phase de la décharge de la ligne Bo', la tension seuil Vt de l'inverseur 18 n'est pas atteinte ; la sortie de la porte 16 reste à "0" et les transistors de sortie M3 restent bloqués. Cette première phase correspond à l'intervalle où la sortie d'une mémoire classique présente un passage intempestif à "0", comme cela est représenté en pointillés pour la sortie Bo1. Ce passage intempestif à "0" est évité, selon l'invention, grâce au fait que les transistors de sortie M3 restent bloqués pendant cette première phase.

Lorsque l'état de la fausse ligne de sortie Bo' atteint la tension seuil Vt, la sortie de l'inverseur 18 passe à "1". Les deux entrées de la porte 16 sont alors à "1", ce qui provoque l'activation de la ligne RC2. Les transistors de sortie M3 deviennent passants, mais comme l'état de la ligne Bo, qui évolue comme celui de la ligne Bo', est en dessous de la tension seuil Vt, le verrou 12, dont l'entrée se trouvait à "0", ne bascule pas. En conséquence, la sortie Bo1 reste continûment à "1" .

Lorsque les lignes R et RC sont désactivées, la ligne RC2 est aussitôt désactivée et les lignes Bo et Bo' sont de nouveau chargées au potentiel Vdd.

Avec cette configuration, on supprime deux transitions, correspondant à un bref passage intempestif à "0", de chaque sortie de la mémoire lors de deux lectures consécutives d'un "1". Bien entendu, l'ajout d'une fausse cellule 10' et d'une fausse ligne de sortie Bo' entraîne une consommation supplémentaire. Cette consommation est toutefois faible par rapport à ce que consommait classiquement un seul passage intempestif à "0" sur une sortie de la mémoire, car les sorties de la mémoire sont reliées à des lignes de longueur importante.

Selon un mode de réalisation de la présente invention, chaque ligne d'entrée Bi est reliée à l'entrée de la mémoire par un transistor MOS à canal N M4. Les grilles des transistors M4 sont reliées à une ligne d'écriture de colonne WC. Comme on l'a précédemment indiqué, la ligne WC est une ligne qui sert à sélectionner la mémoire en écriture ; elle est active en même temps que l'une quelconque des lignes d'écriture W.

Avec cette configuration, tant que la mémoire n'est pas sélectionnée en écriture, les lignes d'entrée Bi sont déconnectées du bus Di et ne contribuent donc pas à augmenter la capacité des lignes du bus Di.

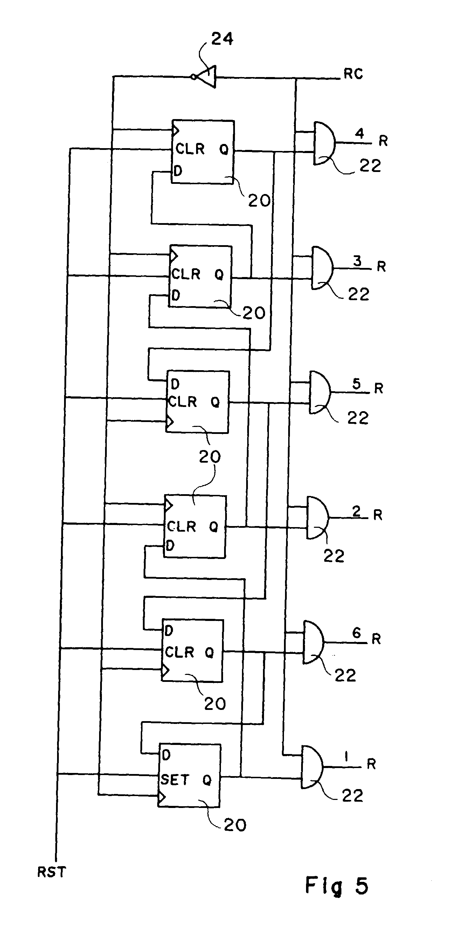

La figure 5 représente un mode de réalisation de circuit de commande des lignes d'écriture W et de lecture R permettant, à l'aide d'une mémoire à double accès, de réaliser une mémoire FIFO de structure particulièrement simple. La figure 5 illustre un exemple où l'on a six lignes de lecture R et six lignes d'écriture W. Un circuit du type de la figure 5 est associé aux six lignes de lecture R et un autre circuit identique est associé aux six lignes d'écriture W. On ne décrit ci-après que le circuit de commande associé aux lignes de lecture.

Ce circuit de commande comprend un registre à décalage à six bascules 20 disposées en cascade, c'est-à-dire que la sortie de chaque bascule est reliée à l'entrée de la bascule suivante. Chaque sortie d'une bascule 20 est fournie à l'une des lignes de lecture R par une porte ET 22. Une deuxième entrée des portes ET 22 est reliée à la ligne de lecture de colonne RC qui est également reliée aux entrées d'horloge des bascules 20 par l'intermédiaire d'un inverseur 24. Un signal d'initialisation RST est fourni à chacune des bascules 20. L'activation de ce signal RST met à "1" la première bascule 20 et toutes les autres à "0". Le registre à décalage est rebouclé, c'est-à-dire que la sortie de la dernière bascule est reliée à l'entrée de la première bascule. Comme cela est représenté, les bascules 20 sont disposées de manière entrelacée, c'est-à-dire que la bascule de dernier rang (6) est disposée entre les bascules de premier rang (1) et deuxième rang (2), que la bascule d'avant dernier rang (5) est disposée entre les bascules de deuxième rang (2) et troisième rang (3)... Avec cette disposition, les connexions entre les bascules sont toutes de sensiblement la même longueur, quel que soit le nombre de bascules, ce qui évite que les bascules aient des délais de commutation différents.

Initialement, par l'activation du signal RST, la bascule de rang 1 est à "1" et toutes les autres à "0". Quand la ligne RC est activée, la première rangée de cellules est sélectionnée en lecture. Lorsque la ligne RC est désactivée, le "1" qui était dans la première bascule 20 se propage dans la deuxième bascule. A la prochaine activation de la ligne RC, c'est la deuxième rangée de cellules qui est sélectionnée en lecture. Lorsque le "1" atteint la dernière bascule (6), il repasse dans la première bascule dès la désactivation suivante du signal RC.

Un circuit de commande identique à celui de la figure 5 est également associé aux lignes d'écriture W. Les lignes d'écriture W sont reliées aux sorties des portes ET 22 et la ligne d'écriture de colonne WC est reliée à l'entrée de l'inverseur 24. Bien entendu, les rangs des bascules peuvent être changés si l'on souhaite lire les données stockées dans un ordre différent de celui de leur écriture.

On obtient ainsi une structure de mémoire FIFO particulièrement simple car les rangées de cellules sont directement sélectionnées par les registres à décalage sans qu'il soit nécessaire d'utiliser un système complexe classique de génération d'adresses et de décodage de ces adresses.

Bien entendu, il faut que les dispositifs qui écrivent ou lisent dans la mémoire FIFO puissent connaître l'état de remplissage de celle-ci. Pour cela, ces dispositifs ont besoin d'un signal FULL indiquant que la mémoire est pleine et éventuellement d'un signal ½FULL indiquant que la mémoire est à moitié pleine.

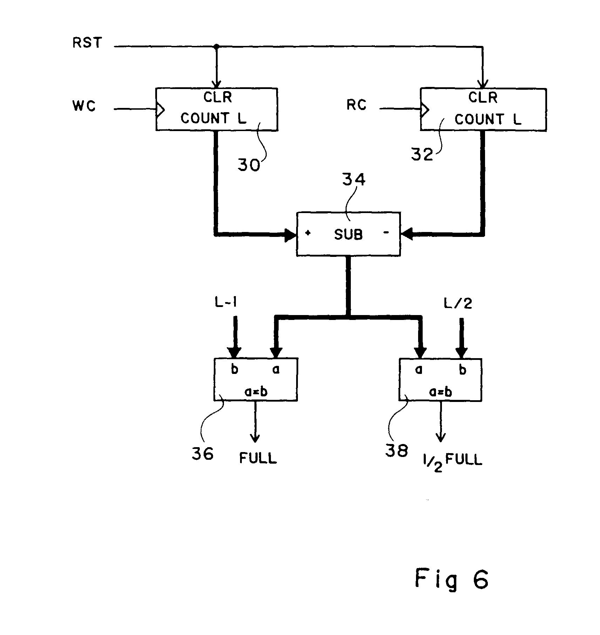

La figure 6 représente schématiquement un circuit permettant d'obtenir de tels signaux FULL et ½FULL.

Ce circuit comprend deux compteurs par L 30 et 32, L étant le nombre de rangées de cellules de la mémoire FIFO (6 dans l'exemple de la figure 5). Le compteur 30 est activé par la ligne d'écriture de colonne WC et le compteur 32 est activé par la ligne de lecture de colonne RC. Les deux compteurs 30 et 32 sont remis à zéro par le signal RST. Les sorties des compteurs 30 et 32 sont fournies à un soustracteur numérique 34 qui fournit la différence entre le contenu du compteur 30 et celui du compteur 32 (c'est-à-dire la différence entre le nombre de données écrites et le nombre de données lues). La sortie du soustracteur 34 est fournie à une entrée a de deux comparateurs 36 et 38. Une entrée b du comparateur 36 reçoit le nombre L-1 et une entrée b du comparateur 38 reçoit le nombre L/2. Le comparateur 36 fournit le signal d'état plein FULL lorsque le résultat de la soustraction dans le soustracteur 34 est égal à L-1 et le comparateur 38 active le signal d'état demi-plein ½FULL lorsque le résultat de la soustraction est égal à L/2.

De nombreuses variantes et modifications de la présente invention apparaitront à l'homme du métier, notamment en ce qui concerne le choix des polarités des signaux et l'adaptation qui en résulte des différents circuits.

## Revendications

1. Mémoire à double accès comprenant :
- des cellules mémoire à double accès (10) disposées en colonnes ;
- une ligne d'entrée (Bi) par colonne reliée à chaque cellule (10) de la colonne par un transistor d'écriture (M1) commandé par une ligne d'écriture (W) respective,
caractérisée en ce qu'elle comprend, pour chaque ligne d'entrée, un transistor (M4) reliant cette ligne d'entrée directement à une entrée de la mémoire et commandé par l'état actif de l'une quelconque des lignes d'écriture (W).

2. Mémoire à double accès selon la revendication 1, caractérisée en ce qu'elle comprend :
- une ligne de sortie (Bo) par colonne reliée à chaque cellule de la colonne par un transistor de lecture (M2) commandé par une ligne de lecture respective (R) ;
- des transistors de précharge (MP1) reliant les lignes de sortie (Bo) à un potentiel de précharge (Vdd) correspondant à un premier état logique, ces transistors étant commandés par un état inactif d'un signal (RC) de sélection en lecture ;
- des transistors de sortie (M3) reliant les lignes de sortie à une sortie (Bo1) de la mémoire ;
- une fausse cellule mémoire (10') associée à une fausse ligne de sortie (Bo') et à un transistor de précharge, la sortie de cette fausse cellule étant à un deuxième état logique opposé audit premier état logique ;
- un faux transistor de lecture (M2') commandé par l'état actif du signal de sélection en lecture (RC) et reliant la sortie de la fausse cellule à la fausse ligne de sortie ; et
- des moyens (16, 18) pour commander lesdits transistors de sortie (M3) lorsque l'état de la fausse ligne de sortie atteint un seuil prédéterminé entre lesdits premier et deuxième états logiques.

3. Mémoire à double accès selon la revendication 2, caractérisée en ce que lesdits moyens pour commander les transistors de sortie (M3) comprennent une porte logique (16) dont une première entrée est reliée à la fausse ligne de sortie (Bo') par l'intermédiaire d'un inverseur (18) et dont une deuxième entrée reçoit le signal de sélection en lecture (RC).

4. Mémoire à double accès selon la revendication 2, caractérisée en ce que ladite fausse cellule (10') comprend un transistor (10-2) conducteur relié à un potentiel fixe correspondant audit deuxième état logique.

## Patentansprüche

1. Doppelzugriffspeicher mit:
- Doppelzugriffspeicherzellen (10), die in Spalten angeordnet sind;
- einer Eingangsleitung (Bi) pro Spalte, die mit jeder Zelle (10) der Spalte über einen Schreibtransistor (M1) verbunden ist, der jeweils über eine Schreibleitung (W) angesteuert wird,
dadurch gekennzeichnet, daß er für jede Eingangsleitung einen Transistor (M4) aufweist, der diese Eingangsleitung direkt mit einem Eingang des Speichers verbindet und durch den aktiven Zustand einer beliebigen Schreibleitung (W) angesteuert wird.

2. Doppelzugriffspeicher nach Anspruch 1, dadurch gekennzeichnet, daß er folgende Merkmale aufweist:
- eine Ausgangsleitung (Bo) pro Spalte, die mit jeder Zelle der Spalte über einen Lesetransistor (M2) verbunden ist, der jeweils durch eine Leseleitung (R) angesteuert wird;
- Vorlasttransistoren (MP1), die die Ausgangsleitungen (Bo) mit einem Vorlastpotential (Vdd) entsprechend einem ersten logischen Zustand verbinden, wobei diese Transistoren durch einen nicht aktiven Zustand eines Auswahllesesignales (RC) angesteuert werden;
- Ausgangstransistoren (M3), die die Ausgangsleitungen mit einem Ausgang (Bol) des Speichers verbinden;
- eine Pseudo-Speicherzelle (10'), die einer Pseudo-Ausgangsleitung (Bo') und einem Vorlasttransistor zugeordnet ist, wobei der Ausgang dieser Pseudo-Zelle auf einem zweiten logischen Zustand ist, der dem ersten logischen Zustand entgegengesetzt ist;
- einen Pseudo-Lesetransistor (M2'), der durch den aktiven Zustand des Auswahllesesignales (RC) angesteuert wird und den Ausgang der Pseudo-Zelle mit einer Pseudo-Ausgangsleitung verbindet; und
- Einrichtungen (16, 18), um die genannten Ausgangstransistoren (M3) anzusteuern, wenn der Zustand der Pseudo-Ausgangsleitung einen vorbestimmten Schwellenwert zwischen dem ersten und dem zweiten Logikzustand erreicht.

3. Doppelzugriffspeicher nach Anspruch 2, dadurch gekennzeichnet, daß die Einrichtungen zum Ansteuern der Ausgangstransistoren (M3) ein logisches Tor (16) aufweisen, dessen erster Eingang mit der Pseudo-Ausgangsleitung (Bo') unter Zwischenschaltung eines Inverters (18) verbunden ist und dessen zweiter Eingang das Auswahllesesignal (RC) empfängt.

4. Doppelzugriffspeicher nach Anspruch 2, dadurch gekennzeichnet, daß die genannte Pseudo-Zelle (10') einen leitenden Transistor (10-2) enthält, der mit einem festen Potential entsprechend dem zweiten logischen Zustand verbunden ist.

## Claims

1. A dual-port memory including:
- dual-port memory cells (10) disposed in columns;
- one input line (Bi) per column connected to each cell (10) of the column through a write transistor (M1) that is turned on by a respective write line (W); characterized in that it comprises,
for each input line, a transistor (M4) directly connecting said input line to a memory input when any of said write lines (W) is at an active state.

2. The dual-port memory of claim 1, including:
- one output line (Bo) per column connected to each cell of the column by a read transistor (M2) that is controlled by a respective read line (R);
- precharge transistors (MP1) connecting the output lines (Bo) to a precharge voltage (Vdd) corresponding to a first logic state, said transistors being turned on by the inactive state of a read selection signal (RC) ;
- output transistors (M3) connecting the output lines to a memory output (Bo1);
- a dummy memory cell (10') associated with a dummy output line (Bo') and with a precharge transistor, the output of said dummy cell being at a second logic state opposite to said first logic state;
- a dummy read transistor (M2') turned on by the active state of the read selection signal (RC) and connecting the output of the dummy cell to the dummy output line; and
- means (16, 18) for turning on said output transistors (M3) when the state of the dummy output line reaches a predetermined threshold between said first and second logic states.

3. The dual-port memory of claim 2, wherein said means for turning on the output transistors (M3) include a logic gate (16) having a first input connected to the dummy output line (Bo') through an inverter (18) and a second input that receives the read selection signal (RC).

4. The dual-port memory of claim 2, wherein said dummy cell (10') includes a conducting transistor (10-2) connected to a fixed voltage corresponding to said second logic state.
